# EUROPEAN PATENT APPLICATION

(11) **EP 4 618 729 A1**
(43) Date of publication of application: **17.09.2025**
(21) Application number: 24875621.5
(22) Date of filing: 03.12.2024
(51) Int. Cl.: H10F 77/30, H10F 71/00, H10F 10/00

(54) **PASSIVATION FILM STRUCTURE CAPABLE OF ACHIEVING BOTH PASSIVATION AND SURFACE DOPING, AND PREPARATION METHOD THEREFOR AND USE THEREOF**

(30) Priority: 23.01.2024 CN 202410092529
(71) Applicant: Teranergy Technology Co., Ltd., Ningbo, Zhejiang 315206 (CN)
(72) Inventor: LIU, Zunke, Ningbo, Zhejiang 315206 (CN); ZENG, Yuheng, Ningbo, Zhejiang 315206 (CN); YE, Jichun, Ningbo, Zhejiang 315206 (CN); OU, Yali, Ningbo, Zhejiang 315206 (CN); ZHOU, Hongkai, Ningbo, Zhejiang 315206 (CN); LIAO, Mingdun, Ningbo, Zhejiang 315206 (CN); LIU, Wei, Ningbo, Zhejiang 315206 (CN)
(74) Representative: Bayramoglu et al.
(86) International application number: PCT/CN2024/136315
(87) International publication number: WO 2025/156826

(57) **Abstract**

The present disclosure provides a passivation film structure with passivation and surface doping, which includes a nano dielectric layer, a silicide layer and a hydrogen-rich dielectric layer sequentially laminated on a surface of a silicon substrate. The material of the nano dielectric layer is hydrogenated silicon oxide film or hydrogenated silicon oxynitride film; the material of the silicide layer is boron/phosphorus-doped hydrogenated carbon and/or nitrogen-containing silicon film; the material of the hydrogen-rich dielectric layer is selected from a laminated film of one or more of hydrogenated aluminum oxide film, hydrogenated silicon nitride film, hydrogenated silicon oxide film, and hydrogenated silicon oxynitride film. This structure has excellent passivation performance and can achieve good passivation effect on polished or textured silicon wafer or boron/phosphorus-diffused emitters. The passivation film structure contains boron/phosphorus element. In the passivation film preparation process, silicon wafer surface doping can be carried out without adding a doping process.

## Description

### TECHNICAL FIELD

The present disclosure relates to the field of surface passivation technologies of silicon solar cells and in particular, to a passivation film structure with passivation and surface doping and a preparation method and application thereof.

### BACKGROUND TECHNOLOGY

Surface passivation is essential for improving the efficiency of silicon solar cells. It can be known from the development trend of the industrialized silicon cells that the efficiency improvement of the cells always goes with each upgrade of passivation technology. The passivated contact technology is the current main research topic of the cells. In the future, in order to eliminate the grid line shading loss of the front surface of the solar cells, the cell structure may shift to back contact. For the back contact cells, the front surface always requires a good passivation solution whether its back surface uses Tunnel Oxide Passivated Contact (TOPcon) structure or Silicon HeteroJunction (SHJ) structure.

The saturated current density (*J*₀) is a physical variable representing the size of surface recombination. The smaller value of the physical variable represents lower surface recombination. The value *J*₀ of the passivation film on different silicon wafers can change depending on the change of the resistivity of the silicon wafers. The saturated current density of the passivation film on different silicon wafers can also change depending on the change of the resistivity of the silicon wafers. At present, the common dielectric passivation films applied to the sun-facing surface (front surface) of the silicon solar cells mainly include: AlOₓ/SiNₓ, SiOₓ/SiNₓ, and SiOₓ/SiNₓ/SiOₓ etc. These passivation films can realize relatively good passivation effect on flat silicon wafers. Specifically, AlOₓ/SiNₓ laminated passivation film has an optimal passivation index of about 2 fA/cm2 on non-diffusion p-type or n-type flat silicon wafers; the passivation effect of SiOₓ/SiNₓ/SiOₓ is generally superior to that of SiOₓ/SiNₓ; and SiOₓ/SiNₓ/SiOₓ has the optimal passivation indexes of ~1 fA/cm2 (high-resistivity silicon wafer, where the resistivity is ~90 Ωcm) and 4.7 fA/cm² (industry-used low-resistivity silicon wafer, where the resistivity is ~3 Qcm) on non-diffusion n-type flat silicon wafers, and has the optimal passivation index of about 3 fA/cm2 (high-resistivity silicon wafer, where the resistivity is ~90 Qcm) on the non-diffusion n-type randomly-textured silicon wafers.

Under the requirements of the industry for increased efficiency and structural evolution of the solar cells, the disadvantages of the existing dielectric passivation films are highlighted, showing the following specific problems: 1) on the flat silicon wafers, the passivation performance of the existing dielectric passivation films remains to be improved. For the crystalline silicon solar cells with the development efficiency above 27.5%, the surface passivation performance is required to be up to 1 fA/cm² but the existing passivation films cannot meet the requirements on the flat silicon wafers. 2) The new efficient back-contact (BC) solar cells have a front surface of random pyramid textured surface structure so as to achieve excellent passivation quality while a diffusion layer is required on the front surface to enhance the radiation-resistant reliability of the cells. However, the passivation quality of the existing passivation films on the textured surface is poorer than that on the flat surface. Furthermore, in the existing processing procedure, an additional diffusion step is required to realize surface doping on the front surface of the silicon wafers. In addition, the passivation quality of the passivation films on the random pyramid textured surface with surface silicide layer may further drop, limiting the improvement of the cell efficiency. 3) For the BC cells based on heterojunction technology, its front surface still needs to be passivated by amorphous silicon. Its passivation quality is good but there is a parasitic absorption. Although the existing common dielectric passivation films can eliminate the parasitic absorption, it still cannot replace amorphous silicon for its passivation quality is far poorer than that of amorphous silicon. Therefore, in the prior arts, for the BC cells based on heterojunction technology, there is a parasitic absorption of amorphous silicon on the front surface, leading to a lower upper limit of the current density, and thus limiting efficiency improvement.

In conclusion, the passivation quality of the passivation films is a key factor restricting the performance improvement of the crystalline silicon solar cells. In order to ensure the efficiency improvement of the silicon solar cells, it is crucial to further improve the passivation quality and lower the saturated current density.

### CONTENT OF THE INVENTION

The object of the present disclosure is to develop a passivation film with passivation and surface doping function to lower a saturated current density and improve a silicon solar cell efficiency.

In order to achieve the above purpose, a first aspect of the present disclosure provides a passivation film structure with passivation and surface doping, which includes a nano dielectric layer, a silicide layer and a hydrogen-rich dielectric layer sequentially laminated on a surface of a silicon substrate. The material of the nano dielectric layer is hydrogenated silicon oxide film or hydrogenated silicon oxynitride film; the material of the silicide layer is boron/phosphorus-doped hydrogenated carbon and/or nitrogen-containing silicon film; the material of the hydrogen-rich dielectric layer is selected from a laminated film of one or more of hydrogenated aluminum oxide film, hydrogenated silicon nitride film, hydrogenated silicon oxide film, and hydrogenated silicon oxynitride film.

The passivation film structure of the present disclosure has excellent passivation performance and can achieve good passivation effect on polished or textured silicon wafer or boron/phosphorus-diffused emitters. The passivation film structure contains boron/phosphorus element. In the passivation film preparation process, silicon wafer surface doping can be carried out without adding a doping process.

Furthermore, a diffusion layer with a thickness of 10 to 1200nm is formed on a surface of the silicon substrate close to the nano dielectric layer. The diffusion layer is doped with boron or phosphorus element. On the surface of the silicon substrate, a phosphorus concentration is 1×10¹⁸cm⁻³ to 1×10²¹cm⁻³ and a boron concentration is 5×10¹⁶cm⁻³ to 5×0²⁰cm⁻³. The passivation film structure realizes shallow diffusion on the surface of the silicon wafer and exerts field passivation effect, helping lower a recombination current.

Furthermore, the boron/phosphorus concentration of the silicide layer is 5×10¹⁹cm⁻³ to 5×10²¹cm⁻³. By adjusting the boron/phosphorus element concentration in the silicide layer, the boron/phosphorus doping concentration of the surface of the silicon wafer can be controlled.

Furthermore, the silicon substrate contains hydrogen element, carbon element and/or nitrogen element, and the concentration of each element gradually drops from surface to inside. On the surface of the silicon substrate, the hydrogen concentration is 1×10¹⁹cm⁻³ to 1×10²¹cm⁻³, the nitrogen concentration is 1×10¹⁹cm⁻³ to 1×10²²cm⁻³, and/or the carbon concentration is 1 × 10¹⁹cm⁻³ to 1 × 10²²cm⁻³.

Furthermore, the carbon concentration of the silicide layer is 1×10²¹cm⁻³ to 2×10²²cm⁻³, and/or the nitrogen concentration is 5 × 10²¹cm⁻³ to 4×10²²cm⁻³.

The carbon and nitrogen atoms can effectively capture hydrogen atoms and inject them into the substrate and interface so as to passivate more defect states. The elements such as carbon and nitrogen are introduced to a subsurface of the silicon wafer, improving the mechanical property of the silicon wafer.

Furthermore, the hydrogen concentration of the nano dielectric layer is 1×10¹⁹cm⁻³ to 1×10²²cm⁻³; the hydrogen concentration of the silicide layer is 1 × 10¹⁹cm⁻³ to 1 × 10²²cm⁻³; and the hydrogen concentration of the hydrogen-rich dielectric layer is 1 × 10¹⁹cm⁻³ to 1 × 10²²cm⁻³. Each layer of the passivation film structure has a high hydrogen concentration as well as a good chemical stability, which can provide excellent surface protection for the silicon wafer.

Furthermore, a refractive index of the silicide layer is 1.5 to 3.0. The refractive index of the silicide layer can be controlled by component adjustment.

Furthermore, a transmittance of the nano dielectric layer for the wavelength of above 400nm is greater than 97%, and a transmittance of the silicide layer for the wavelength of above 400nm is greater than 97%. The absorption of the passivation film structure for the wavelength of above 400nm is extremely low, resulting in extremely low optical absorption characteristics.

Furthermore, a thickness of the nano dielectric layer is 1 to 2nm, and a thickness of the silicide layer is greater than or equal to 3nm. The controllable adjustment to the optical absorption and transmittance characteristics of the passivation film structure can be realized by film thickness adjustment.

A second aspect of the present disclosure provides a preparation method of the above passivation film structure with passivation and surface doping, which includes the following steps:
at step S1, cleaning a silicon substrate;
at step S2, preparing a silicon oxide film or a silicon oxynitride film on a surface of the silicon substrate;
at step S3, depositing a carbon and/or nitrogen element-containing amorphous silicon film and doping boron or phosphorus atoms;
at step S4, performing high-temperature annealing treatment to enable phosphorus or boron atoms to diffuse into the silicon substrate and form a diffusion layer on the surface of the silicon substrate while carbon and/or nitrogen elements diffuse into the silicon substrate;
at step S5, depositing a laminated film of one or more of aluminum oxide, silicon nitride, silicon oxide, and silicon oxynitride;
at step S6, performing hydrogen injection treatment to inject hydrogen atoms into the passivation film structure and the silicon substrate.

The preparation method of the passivation film structure of the present disclosure is fully compatible with the existing cell production line technology, and has good application prospect for mass production. The passivation film structure has good thermal stability and its passivation quality is free from the temperature influence in the temperature range of not higher than 500°C.

Furthermore, in the step S3, the doping method includes depositing boron or phosphorus-containing amorphous silicon film below or above the carbon and/or nitrogen element-containing amorphous silicon film, or directly adding active boron or phosphorus atoms into the carbon and/or nitrogen element-containing amorphous silicon film. The high-temperature annealing step includes diffusing the active phosphorus or boron atoms into the silicon substrate, so as to realize silicon wafer surface doping without adding a doping process.

A third aspect of the present disclosure provides a silicon solar cell, which includes the above passivation film structure with passivation and surface doping. The passivation film structure can improve the passivation quality of the silicon solar cell, significantly reduce its saturated current density, and extend the lifespan of the silicon wafer, helping improve the cell efficiency.

In conclusion, the present disclosure has the following beneficial effects as compared with the prior arts.
(1) The passivation film structure of the present disclosure has excellent surface passivation effect. On the surface of the polished silicon wafer, the saturated current density is made lower than 1 fA/cm² and even lowered to 0.2 fA/cm². On the surface of the textured silicon wafer, *J*₀ can also be lower than 1 fA/cm² and even lowered to 0.5 fA/cm². On the boron or phosphorus-diffused emitter, good passivation effect can also be achieved.
(2) The passivation film structure of the present disclosure has excellent body passivation effect, and the body lifespan of the mainstream n-type silicon wafers (1-7 Ωcm) on the market can be increased to more than 15ms.
(3) The passivation film structure of the present disclosure forms a shallow diffusion layer on the surface of the silicon wafer, which can exert the field passivation effect to further improve the passivation effect.
(4) The passivation film structure of the present disclosure has extremely low optical absorption characteristics, for example, has extremely low absorption for the wavelength of above 400nm, and its refractive index can be tuned based on components. Further, by adjusting the refractive index and the film thickness and so on, controllable adjustment to the optical absorption and transmittance characteristics can be realized.
(5) The transparent laminated passivation film structure of the present disclosure has good chemical stability and thermal stability. The passivation film structure contains silicon, nitrogen, carbon and oxygen etc. which can provide excellent surface protection for the silicon wafer. Within the temperature range of lower than 500°C, its passivation quality is free from the temperature influence.
(6) In the passivation film structure of the present disclosure, the elements such as carbon and nitrogen can be introduced to a subsurface of the silicon wafer, helping improve the mechanical property of the silicon wafer.
(7) The preparation method of the passivation film structure of the present disclosure is fully compatible with the existing cell production line technology, and has good application prospect for mass production. Another transparent dielectric film can also be laminated above the passivation film structure to form a more complex film system structure.

### DESCRIPTION OF THE DRAWINGS

FIG. 1 is a structural schematic diagram illustrating a passivation film structure with passivation and surface doping according to a specific example of the present disclosure.
FIG. 2 is a flowchart illustrating a preparation method of the passivation film structure with passivation and surface doping according to a specific example of the present disclosure.
FIG. 3 is a curve diagram illustrating active atom diffusion of a silicon wafer according to examples 1 to 7 of the present disclosure.
FIG. 4 is a curve diagram illustrating a refractive index and an extinction coefficient of a passivation film according to an example 8 of the present disclosure.

The numerals of drawings are described below:
1. silicon substrate, 2. nano dielectric layer, 3. silicide layer, 4. hydrogen-rich dielectric layer and 5. diffusion layer.

### SPECIFIC IMPLEMENTATIONS

In order to make the above objects, features and advantages of the present disclosure clearer and more intelligible, the specific examples of the present disclosure will be detailed below in combination with drawings. It should be noted that the examples below are used only to illustrate the implementation method and typical parameters of the present disclosure rather than to limit the parameter range of the present disclosure. Any reasonable change derived therefrom will still fall within the scope of protection of the claims of the present disclosure.

It should be noted that the endpoints and any values of the ranges disclosed herein are not limited to such accurate ranges or values. These ranges or values should be understood as including values close to these ranges or values. For the numerical ranges, mutual combination can be performed between the endpoint values of each range, between an endpoint value of each range and an individual point value and between individual point values to form one or more new numerical ranges. These numerical ranges shall be considered as specifically disclosed herein.

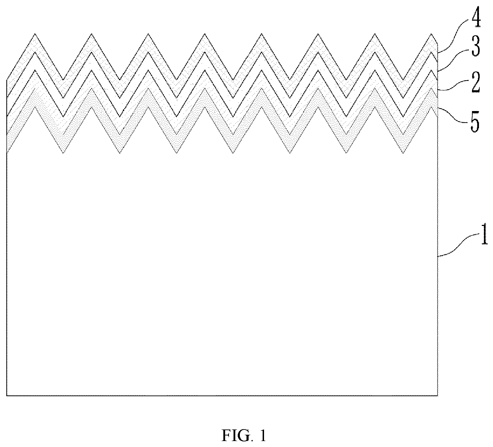

A specific example of the present disclosure provides a passivation film structure with passivation and surface doping, with its typical structure shown in FIG. 1. The structure includes a nano dielectric layer 2, a silicide layer 3 and a hydrogen-rich dielectric layer 4 sequentially laminated on a surface of a silicon substrate 1.

The surface of the silicon substrate 1 is a textured or flat surface structure. A diffusion layer 5 with a thickness of 10 to 1200nm is formed on a surface area below the nano dielectric layer 2. The diffusion layer 5 is doped with boron or phosphorus element, and the phosphorus concentration of the surface is 1×10¹⁸cm⁻³ to 1×10²¹cm⁻³ or the boron concentration is 5×10¹⁶cm⁻³ to 5×10²⁰cm⁻³. Shallow diffusion is realized on the silicon wafer surface so as to exert the field passivation effect. The subsurface and body area of the silicon substrate 1 contain hydrogen, nitrogen and/or carbon elements, and the corresponding element concentration gradually drops from surface to inside. In the surface area below the nano dielectric layer 2, the nitrogen concentration is usually higher than 1 × 10¹⁹cm⁻³, and the typical concentration range is 1 × 10¹⁹cm⁻³ to 1 × 10²²cm⁻³, and also usually goes beyond 1 × 10²⁰cm⁻³; the carbon concentration is usually higher than 1 × 10¹⁹cm⁻³, and the typical concentration range is 1×10¹⁹cm⁻³ to 1×10²²cm⁻³, and also usually goes beyond 1×10²⁰cm⁻³; the hydrogen concentration is usually higher than 1×10¹⁹cm⁻³, and the typical concentration range is 1×10¹⁹cm⁻³ to 1×10²¹cm⁻³, and also usually goes beyond 1×10²⁰cm⁻³. The elements such as carbon and nitrogen are introduced to the subsurface of the silicon wafer to improve the mechanical property of the silicon wafer. The carbon and nitrogen atoms can effectively capture hydrogen atoms and inject them into the substrate and interface so as to passivate more defect states.

The material of the nano dielectric layer 2 is a hydrogenated silicon oxide film or hydrogenated silicon oxynitride film, and mainly contains silicon, oxygen and hydrogen and may also contain nitrogen. In the nano dielectric layer 2, the hydrogen concentration is > 1 × 10¹⁹cm⁻³, and the typical hydrogen concentration range is 1 × 10¹⁹cm⁻³ to 1 × 10²²cm⁻³. Its thickness is above 1nm and its typical thickness range is 1 to 2nm. The transmittance of the nano dielectric layer 2 for the wavelength of above 400nm is greater than 97%, and the absorption coefficient k value drops to near 0 for the wavelength of above 400nm. It has extremely low optical absorption characteristics.

The material of the silicide layer 3 is a boron/phosphorus-doped hydrogenated carbon and/or nitrogen-containing silicon film, such as a boron-doped hydrogenated carbon-nitrogen-silicon film, a boron-doped hydrogenated carbon-silicon film, a boron-doped hydrogenated nitrogen-silicon film, a phosphorus-doped hydrogenated carbon-nitrogen-silicon film, a phosphorus-doped hydrogenated carbon-silicon film and a phosphorus-doped hydrogenated nitrogen-silicon film. The silicide layer 3 may also contain oxygen element, such as a boron-doped hydrogenated carbon-nitrogen-oxygen-silicon film, a boron-doped hydrogenated carbon-oxygen-silicon film, a boron-doped hydrogenated nitrogen-oxygen-silicon film, a phosphorus-doped hydrogenated carbon-nitrogen-oxygen-silicon film, a phosphorus-doped hydrogenated carbon-oxygen-silicon film, and a phosphorus-doped hydrogenated nitrogen-oxygen-silicon film. Its thickness is above 3nm and the typical thickness range is 3 to 50nm. The carbon concentration of the silicide layer 3 is 1×10²¹cm⁻³ to 2×10²²cm⁻³, and/or the nitrogen concentration is 5×10²¹cm⁻³ to 4×10²²cm⁻³. The ratios of carbon and nitrogen elements etc. in the silicide layer 3 can be adjusted and the range of its refractive index is 1.5 to 3.0 and can be adjusted based on components. In the silicide layer 3, the boron/phosphorus concentration is 5×10¹⁹cm⁻³ to 5×10²¹cm⁻³ . By adjusting the boron/phosphorus element concentration in the silicide layer 3, the boron/phosphorus doping concentration on the surface of the silicon substrate 1 can be controlled. In the silicide layer 3, the hydrogen concentration is >1×10¹⁹cm⁻³, and its typical concentration range is 1×10¹⁹cm⁻³ to 1×10²²cm⁻³. The transmittance of the silicide layer 3 for the wavelength of above 400nm is greater than 97%, and the absorption coefficient k value drops to near 0 for the wavelength of above 400nm. It has extremely low optical absorption characteristics.

The material of the hydrogen-rich dielectric layer 4 is a laminated film of hydrogenated aluminum oxide, hydrogenated silicon nitride, hydrogenated silicon oxide, hydrogenated silicon oxynitride or a combination thereof. The hydrogen concentration of the hydrogen-rich dielectric layer 4 is 1×10²⁰cm⁻³ to 1×10²²cm⁻³. The hydrogen-rich dielectric layer may also contain boron or phosphorus element.

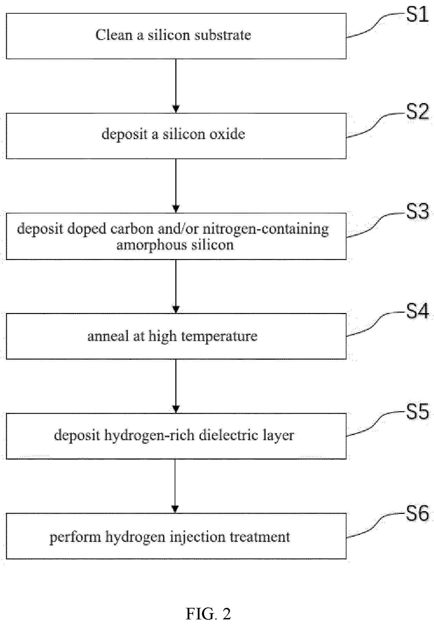

As shown in FIG. 2, the typical preparation method of the above transparent laminated passivation film structure includes the following steps.

At step S1, standard RCA cleaning is performed on a silicon substrate.

At step S2, a silicon oxide film or a silicon oxynitride film is prepared on a surface of the silicon substrate. The preparation method includes wet chemical method, plasma-assisted oxidation method, thermal oxidation method, and ozone oxidation method and the like.

At step S3, a carbon and/or nitrogen element-containing amorphous silicon film is deposited on the silicon oxide film or the silicon oxynitride film. The typical method is Plasma Enhanced Chemical Vapor Deposition (PECVD) which is an in-situ deposition method with a deposition temperature of 100°C to 600°C. Further, boron or phosphorus atoms are doped. The doping method is depositing a boron or phosphorus-containing amorphous silicon film above or below the carbon and/or nitrogen element-containing amorphous silicon film, or directly adding active boron or phosphorus atoms to the carbon and/or nitrogen element-containing amorphous silicon film.

At step S4, high-temperature annealing treatment is performed to enable active phosphorus or boron atoms to diffuse into the silicon substrate and form a diffusion layer on the surface of the silicon substrate while carbon and/or nitrogen elements diffuse into the silicon substrate. The typical temperature range is 600°C to 1200°C and preferably 900 to 950°C. if the doping is performed by depositing a boron or phosphorus-containing amorphous silicon film above the carbon and/or nitrogen element-containing amorphous silicon film, the boron or phosphorus-containing amorphous silicon film can be removed by using an alkaline solution after high-temperature annealing, so as to further improve the light transmittance.

At step S5, a laminated film of one or more of aluminum oxide, silicon nitride, silicon oxide, and silicon oxynitride is deposited on the silicide layer.

At step S6, hydrogen injection treatment is performed to inject hydrogen atoms into the passivation film structure and the silicon substrate. The hydrogen injection method is annealing hydrogenation treatment or light injection.

In the above preparation method, the active phosphorus or boron atoms are diffused into the silicon substrate to realize doping on the surface of the silicon wafer, and the carbon and nitrogen atoms are introduced into the silicon wafer and can capture more hydrogen atoms at the interface. The transparent laminated passivation film structure realizes excellent surface passivation effect and body passivation effect.

The above passivation film structure is applicable to the silicon solar cell and the preparation method is fully compatible with the existing cell production line technology. The passivation film structure can improve the passivation quality of the silicon solar cell, significantly reduce its saturated current density, and extend the lifespan of the silicon wafer, helping improve the cell efficiency. Another transparent dielectric film can also be laminated above the passivation film structure to form a more complex film system structure.

The technical solutions and effects of the present disclosure will be detailed below by way of specific examples.

### Example 1

An n-type silicon wafer was prepared and polished with alkali. The thickness was 110µm and the resistivity was 1 to 7 Ω·cm. The silicon wafer was subjected to standard RCA cleaning and then placed into a PECVD chamber. SiOₓ film was prepared by N₂O plasma, and then a nitrogen-rich amorphous silicon film was deposited (the nitrogen concentration was 1×10²²cm⁻³), and then an ultrathin phosphorus-containing amorphous silicon film was deposited; high-temperature annealing was performed at 900°C for 30min in a tubular furnace; AlOₓ was deposited by ALD, and annealed for 30min at 450°C in the tubular furnace and then transferred to the PECVD for SiNₓ deposition and finally in the tubular furnace, annealing was performed at 400°C for 60min under the atmosphere of mixture of nitrogen and hydrogen. Six samples were prepared for Sinton test. The single-face saturated current density *J*_{0,s} had a test result range of 0.5 to 0.8 fA/cm².

### Example 2

An n-type silicon wafer was prepared and polished with alkali. The thickness was 110µm and the resistivity was 1 to 7 Ω·cm. The silicon wafer was subjected to standard RCA cleaning and then placed into a PECVD chamber. SiOₓ film was prepared by N₂O plasma, and then a nitrogen-rich amorphous silicon film was deposited (the nitrogen concentration was 1×10²²cm⁻³), and then an ultrathin phosphorus-containing amorphous silicon film was deposited; high-temperature annealing was performed at 950°C for 30min in a tubular furnace; AlOₓ was deposited by ALD, and annealed for 30min at 450°C in the tubular furnace and then transferred to the PECVD for SiNₓ deposition and finally in the tubular furnace, annealing was performed at 400°C for 60min under the atmosphere of mixture of nitrogen and hydrogen. Six samples were prepared for Sinton test. The single-face saturated current density *J*_{0,s} had a test result range of 0.9 to 1.4 fA/cm².

### Example 3

A p-type silicon wafer was prepared and polished with alkali. The thickness was 110µm and the resistivity was 1 to 7 Ω·cm. The silicon wafer was subjected to standard RCA cleaning and then placed into a PECVD chamber. SiOₓ film was prepared by N₂O plasma, and then a nitrogen-rich amorphous silicon film was deposited (the nitrogen concentration was 1×10²²cm⁻³), and then an ultrathin boron-containing amorphous silicon film was deposited; high-temperature annealing was performed at 900°C for 30min in a tubular furnace; AlOₓ was deposited by ALD, and annealed for 30min at 450°C in the tubular furnace and then transferred to the PECVD for SiNₓ deposition and finally in the tubular furnace, annealing was performed at 400°C for 60min under the atmosphere of mixture of nitrogen and hydrogen. Six samples were prepared for Sinton test. The single-face saturated current density *J*_{0,s} had a test result range of 0.2 to 0.5 fA/cm².

### Example 4

A p-type silicon wafer was prepared and polished with alkali. The thickness was 110µm and the resistivity was 1 to 7 Ω·cm. The silicon wafer was subjected to standard RCA cleaning and then placed into a PECVD chamber. SiOₓ film was prepared by N₂O plasma, and then a nitrogen-rich amorphous silicon film was deposited (the nitrogen concentration was 1×10²²cm⁻³), and then an ultrathin boron-containing amorphous silicon film was deposited; high-temperature annealing was performed at 950°C for 30min in a tubular furnace; AlOₓ was deposited by ALD, and annealed for 30min at 450°C in the tubular furnace and then transferred to the PECVD for SiNₓ deposition and finally in the tubular furnace, annealing was performed at 400°C for 60min under the atmosphere of the mixture of nitrogen and hydrogen. Six samples were prepared for Sinton test. The single-face saturated current density *J*_{0,s} had a test result range of 0.7 to 1.2 fA/cm².

### Example 5

An n-type silicon wafer was prepared and textured. The thickness was 200µm and the resistivity was 1 to 7 Ω·cm. The silicon wafer was subjected to standard RCA cleaning and then placed into a PECVD chamber. SiOₓ film was prepared by N₂O plasma, and then a nitrogen-rich amorphous silicon film was deposited (the nitrogen concentration was 1×10²²cm⁻³), and then an ultrathin phosphorus-containing amorphous silicon film was deposited; high-temperature annealing was performed at 900°C for 30min in a tubular furnace; AlOₓ was deposited by ALD, and annealed for 30min at 450°C in the tubular furnace, and then transferred to the PECVD for SiNₓ deposition and finally in the tubular furnace, annealing was performed at 400°C for 60min under the atmosphere of mixture of nitrogen and hydrogen. Six samples were prepared for Sinton test. The single-face saturated current density *J*_{0,s} had a test result range of 0.5 to 1.0 fA/cm².

### Example 6

An n-type silicon wafer was prepared and polished with alkali. The thickness was 110µm and the resistivity was 1 to 7 Ω·cm. The silicon wafer was subjected to standard RCA cleaning and then placed into a PECVD chamber. SiOₓ film was prepared by N₂O plasma, and then a nitrogen-and-carbon-rich amorphous silicon film was deposited (the nitrogen concentration was 5×10²¹cm⁻³ and the carbon concentration was 5×10²¹cm⁻³), and active phosphorus atoms were added; in a tubular furnace, high-temperature annealing was performed at 900°C for 30min; AlOₓ was deposited by ALD, and annealed for 30min at 450°C in the tubular furnace and then transferred to the PECVD for SiNₓ deposition and finally in the tubular furnace, annealing was performed at 400°C for 60min under the atmosphere of the mixture of nitrogen and hydrogen. Six samples were prepared for Sinton test. The single-face saturated current density *J*_{0,s} had a test result range of 0.4 to 0.8 fA/cm².

### Example 7

An n-type silicon wafer was prepared and polished with alkali. The thickness was 110µm and the resistivity was 1 to 7 Ω·cm. The silicon wafer was subjected to standard RCA cleaning and then placed into a PECVD chamber. SiOₓ film was prepared by N₂O plasma, and then a nitrogen-and-carbon-rich amorphous silicon film was deposited (the nitrogen concentration was 5×10²¹cm⁻³ and the carbon concentration was 5×10²¹cm⁻³), and active phosphorus atoms were added; in a tubular furnace, high-temperature annealing was performed at 950°C for 30min; AlOₓ was deposited by ALD, and annealed for 30min at 450°C in the tubular furnace and then transferred to the PECVD for SiNₓ deposition and finally in the tubular furnace, annealing was performed at 400°C for 60min under the atmosphere of mixture of nitrogen and hydrogen. Six samples were prepared for Sinton test. The single-face saturated current density *J*_{0,s} had a test result range of 1.0 to 1.5 fA/cm².

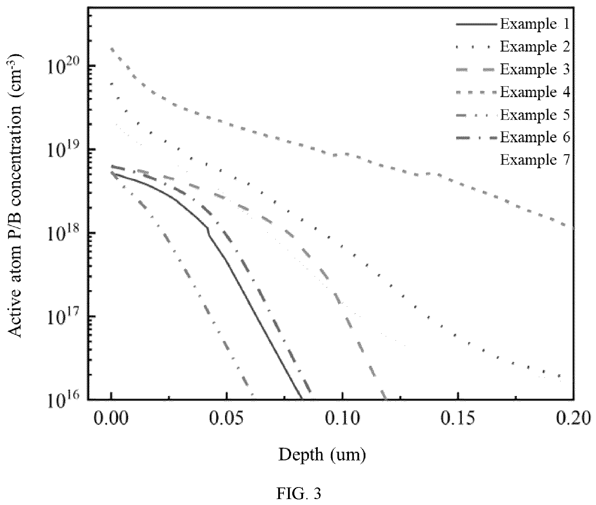

The diffusion curve of the active phosphorus/boron atoms in the silicon wafers in the samples in the examples 1 to 7 is tested. The test results are as shown in FIG. 3. The active atom concentration on the surface of the silicon wafers is 1×10¹⁸cm⁻³ to 1×10²¹cm⁻³, and the diffusion depth is 600 to 1200nm.

### Control example 1

An n-type silicon wafer was prepared and polished with alkali. The thickness was 110µm and the resistivity was 1 to 7 Ω·cm. The silicon wafer was subjected to standard RCA cleaning and then placed into an ALD chamber. Then AlOₓ was deposited on the silicon wafer and then transferred to a tubular furnace and annealed at 450°C for 30min under the atmosphere of nitrogen. Six samples were prepared for Sinton test. The single-face saturated current density *J*_{0,s} had a test result range of 3.0 to 5.0 fA/cm².

### Control example 2

An n-type silicon wafer was prepared and polished with alkali. The thickness was 110µm and the resistivity was 1 to 7 Ω·cm. The silicon wafer was subjected to standard RCA cleaning and then placed into an ALD chamber. Then AlOₓ was deposited on the silicon wafer and then transferred to a tubular furnace and annealed at 450°C for 30min under the atmosphere of nitrogen, then transferred to the PECVD for SiNₓ deposition, and finally transferred to the tubular furnace, and annealed at 400°C for 60min under the atmosphere of the mixture of nitrogen/hydrogen. Six samples were prepared for Sinton test. The single-face saturated current density *J*_{0,s} had a test result range of 2.0 to 4.0 fA/cm².

### Control example 3

An n-type silicon wafer was prepared and textured. The thickness was 200µm and the resistivity was 1 to 7 Ω·cm. The silicon wafer was subjected to standard RCA cleaning and then placed into an ALD chamber. Then AlOₓ was deposited on the silicon wafer and then transferred to a tubular furnace and annealed at 450°C for 30min under the atmosphere of nitrogen, then transferred to the PECVD for SiNₓ deposition, and finally transferred to the tubular furnace, and annealed at 400°C for 60min under the atmosphere of the mixture of nitrogen/hydrogen. Six samples were prepared for Sinton test. The single-face saturated current density *J*_{0,s} had a test result range of 6.0 to 9.0 fA/cm².

### Control example 4

An n-type silicon wafer was prepared and polished with alkali. The thickness was 110µm and the resistivity was 1 to 7 Ω·cm. The silicon wafer was subjected to standard RCA cleaning and then placed into a tubular furnace. SiOₓ was prepared under the atmosphere of oxygen and then transferred to a PECVD chamber for SiNₓ deposition, and finally, in the tubular furnace, annealed at 400°C for 60min under the atmosphere of the mixture of nitrogen/hydrogen. Six samples were prepared for Sinton test. The single-face saturated current density *J*_{0,s} had a test result range of 8.0 to 12.0 fA/cm².

The single-face saturated current density (*J*_{0,s}) and the implied open-circuit voltage (*iV_{oc}*) of the passivation slice prepared in the examples 1 to 7 and the control examples 1 to 4 are tested. The test results are as shown in Table 1 below. The results show that the passivation film structure of the present disclosure has excellent passivation effect and can greatly reduce the saturated current density on the surface of the polished and textured silicon wafers and increase the implied open circuit voltage.

**Table 1 comparison of single-face saturated current densities of the passivation structures in the examples 1 to 7 and the control examples 1 to 4**

| Parameters | *J*_{0,s}(fA/cm²) | *iV_{oc}(*mV*)* |
|---|---|---|
| Example 1 | 0.5 to 0.8 | 755 to 757 |
| Example 2 | 0.9 to 1.4 | 752 to 755 |
| Example 3 | 0.2 to 0.5 | 755 to 758 |
| Example 4 | 0.7 to 1.2 | 753 to 756 |
| Example 5 | 0.5 to 1 | 750 to 753 |
| Example 6 | 0.4 to 0.8 | 752 to 757 |
| Example 7 | 0.9 to 1.3 | 750 to 753 |
| Control example 1 | 3.0 to 5.0 | 730 to 740 |
| Control example 2 | 2.0 to 4.0 | 735 to 745 |
| Control example 3 | 6.0 to 9.0 | 732 to 742 |
| Control example 4 | 8.0 to 12.0 | 720to 730 |

### Example 8

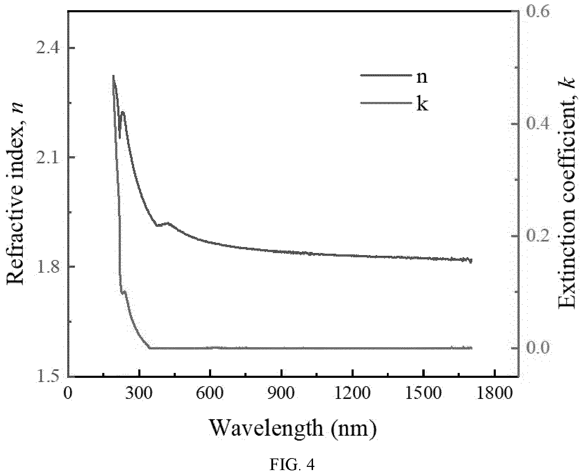

On a quartz substrate, a nitrogen-and-carbon-rich amorphous silicon film was deposited (the nitrogen content is 10 at% and the carbon content is 5 at%) and active phosphorus atoms were added. In a tubular furnace, annealing was performed at 900°C for 30min. Ellipsometry test was performed on the refractive index n and the extinction coefficient k of the film. The results were as shown in FIG. 4. The refractive index was 1.8 to 2.4, and the absorption coefficient k for the wavelength of above 400nm was near 0.

### Example 9

A back contact cell was prepared. The back surface of the cell used TOPCon structure and the front surface was textured surface. The new passivation structure was prepared by the method in the example 4.

### Control example 5

A back contact cell was prepared. The back surface of the cell used TOPCon structure and the front surface was textured surface. The AlOₓ/SiNₓ passivation structure was prepared by the method in the control example 2.

Compared with the cell of the example 9, the control example 5 has a different passivation structure on the front surface. The cell performance is tested with the results shown in Table 2 below. The results show that the passivation structure of the present disclosure can improve the cell efficiency.

**Table 2 Cell performance of the example 9 and the control example 5**

| Parameter | *V*_{oc} (mV) | *J*_{sc} (mA/cm²) | *FF(%)* | Eff (%) |
|---|---|---|---|---|
| Example 9 | 732.0 | 43.25 | 85.81 | 27.17 |
| Control example 5 | 728.5 | 43.30 | 85.63 | 27.01 |

Although the present disclosure is made above, the present disclosure is not limited hereto. Any persons skilled in the arts can make various changes and modifications within the spirit and scope of the present disclosure. Therefore, the scope of protection of the present disclosure shall be indicated by the scope of the claims.

## Claims

1. A passivation film structure with passivation and surface doping, wherein the structure includes a nano dielectric layer, a silicide layer and a hydrogen-rich dielectric layer sequentially laminated on a surface of a silicon substrate; the material of the nano dielectric layer is hydrogenated silicon oxide film or hydrogenated silicon oxynitride film; the material of the silicide layer is boron/phosphorus-doped hydrogenated carbon and/or nitrogen-containing silicon film; the material of the hydrogen-rich dielectric layer is selected from a laminated film of one or more of hydrogenated aluminum oxide film, hydrogenated silicon nitride film, hydrogenated silicon oxide film, and hydrogenated silicon oxynitride film.

2. The passivation film structure with passivation and surface doping of claim 1, wherein a diffusion layer with a thickness of 10 to 1200nm is formed on a surface of the silicon substrate close to the nano dielectric layer; the diffusion layer is doped with boron or phosphorus element; on the surface of the silicon substrate, a phosphorus concentration is 1×10¹⁸cm⁻³ to 1×10²¹cm⁻³ and a boron concentration is 5×10¹⁶cm⁻³ to 5×10²⁰cm⁻³.

3. The passivation film structure with passivation and surface doping of claim 2, wherein the boron/phosphorus concentration of the silicide layer is 5 × 10¹⁹cm⁻³ to 5×10²¹cm⁻³.

4. The passivation film structure with passivation and surface doping of claim 1, wherein the carbon concentration of the silicide layer is 1×10²¹cm⁻³ to 2×10²²cm⁻³, and/or the nitrogen concentration is 5×10²¹cm⁻³ to 4×10²²cm⁻³.

5. The passivation film structure with passivation and surface doping of claim 1, wherein the silicon substrate contains hydrogen element, carbon element and/or nitrogen element, and the concentration of each element gradually drops from surface to inside; on the surface of the silicon substrate, the hydrogen concentration is 1×10¹⁹cm⁻³ to 1×10²¹cm⁻³, the nitrogen concentration is 1×10¹⁹cm⁻³ to 1×10²²cm⁻³, and/or the carbon concentration is 1× 10¹⁹cm⁻³ to 1×10²²cm⁻³.

6. The passivation film structure with passivation and surface doping of any one claim of claims 1-5, wherein the hydrogen concentration of the nano dielectric layer is 1×10¹⁹cm⁻³ to 1×10²²cm⁻³; the hydrogen concentration of the silicide layer is 1×10¹⁹cm⁻³ to 1 × 10²²cm⁻³; and the hydrogen concentration of the hydrogen-rich dielectric layer is 1 × 10¹⁹cm⁻³ to 1 × 10²²cm⁻³.

7. The passivation film structure with passivation and surface doping of claim 6, wherein a refractive index of the silicide layer is 1.5 to 3.0.

8. The passivation film structure with passivation and surface doping of claim 6, wherein a transmittance of the nano dielectric layer for the wavelength of above 400nm is greater than 97%, and a transmittance of the silicide layer for the wavelength of above 400nm is greater than 97%.

9. The passivation film structure with passivation and surface doping of claim 6, wherein a thickness of the nano dielectric layer is 1 to 2nm, and a thickness of the silicide layer is greater than or equal to 3nm.

10. A preparation method of the passivation film structure with passivation and surface doping of any one claim of claims 1-9, wherein it includes the following steps:
at step S1, cleaning a silicon substrate;
at step S2, preparing a silicon oxide film or a silicon oxynitride film on a surface of the silicon substrate;
at step S3, depositing a carbon and/or nitrogen element-containing amorphous silicon film and doping boron or phosphorus atoms;
at step S4, performing high-temperature annealing treatment to enable phosphorus or boron atoms to diffuse into the silicon substrate and form a diffusion layer on the surface of the silicon substrate while carbon and/or nitrogen elements diffuse into the silicon substrate;
at step S5, depositing a laminated film of one or more of aluminum oxide, silicon nitride, silicon oxide, and silicon oxynitride;
at step S6, performing hydrogen injection treatment to inject hydrogen atoms into the passivation film structure and the silicon substrate.

11. The preparation method of the passivation film structure with passivation and surface doping of claim 10, wherein in the step S3, the doping method includes depositing boron or phosphorus-containing amorphous silicon film below or above the carbon and/or nitrogen element-containing amorphous silicon film, or directly adding active boron or phosphorus atoms into the carbon and/or nitrogen element-containing amorphous silicon film.

12. A silicon solar cell, wherein the cell includes the passivation film structure with passivation and surface doping of any one claim of claims 1-9.
